# FASCICULE DE BREVET EUROPEEN

(11) **EP 0 954 094 B1**
(45) Date de publication et mention de la délivrance du brevet: **19.12.2007**
(21) Numéro de dépôt: 99201214.6
(22) Date de dépôt: 20.04.1999
(51) Int. Cl.: H03F 1/32

(54) **Etage de sortie pour amplificateur muni d'un limiteur de courants parasites**
Verstärkerausgangsstufe mit Begrenzer für parasitäre Ströme
Amplifier output stage with parasitic currents limiter

(30) Priorité: 30.04.1998 FR 9805470
(43) Date de publication de la demande: 03.11.1999
(73) Titulaire: NXP B.V., 5656 AG Eindhoven (NL)
(72) Inventeur: Chevallier, Gilles, 75008 Paris (FR)
(74) Mandataire: White, Andrew Gordon

(56) Documents cités:
- EP-A- 0 150 366
- EP-A- 0 339 736
- US-A- 4 764 736
- US-A- 5 545 918
- PATENT ABSTRACTS OF JAPAN vol. 005, no. 117 (E-067), 28 juillet 1981 (1981-07-28) & JP 56 056014 A (TOSHIBA CORP), 16 mai 1981 (1981-05-16)

## Description

La présente invention concerne un étage de sortie pour amplificateur, comportant un premier et un deuxième transistor, chacun muni d'une borne de polarisation, d'une borne de référence et d'une borne de transfert, lesdits transistors ayant leurs trajets de courant principaux disposés entre une première et une deuxième borne d'alimentation, un noeud intermédiaire entre lesdits trajets de courant formant une borne de sortie de l'étage, la borne de polarisation du premier transistor étant reliée à une sortie de l'amplificateur, la borne de polarisation du deuxième transistor étant reliée à une entrée de l'amplificateur via un circuit de polarisation.

De tels étages de sortie sont d'usage courant dans l'industrie des circuits intégrés. Ils ont pour avantage d'opérer une amplification d'un signal présent à la sortie de l'amplificateur au prix d'une faible dissipation d'énergie. L'étage de sortie connu présente toutefois un inconvénient majeur, qui apparaît lorsque le deuxième transistor entre en régime de saturation. Dans cet état, le deuxième transistor présente un transistor parasite ayant un type de conductivité opposé à celui du deuxième transistor, transistor parasite dont les bornes de polarisation, de référence et de transfert, sont respectivement constituées par la borne de transfert, la borne de polarisation et le substrat du deuxième transistor. Le deuxième transistor étant saturé, il reçoit sur sa borne de polarisation un courant dit de polarisation qui est dirigé, via le trajet de courant principal du transistor parasite, vers le substrat. Si l'impédance de la borne de polarisation du deuxième transistor est faible, rien ne limite la valeur du courant de polarisation, ce qui est précisément le cas pour les étages de sortie connus, dans lesquels la borne de polarisation du deuxième transistor est reliée à l'entrée de l'amplificateur, dont l'impédance équivalente est nécessairement faible. Cette liaison est réalisée soit directement, soit via un circuit de polarisation qui peut comporter une diode reliée à une borne d'alimentation via le trajet de courant principal d'un transistor dont la borne de polarisation est reliée à l'entrée de l'amplificateur, mais le circuit de polarisation ne présente en aucun cas une impédance suffisante pour limiter le courant de polarisation du deuxième transistor. La valeur dudit courant de polarisation n'étant pas limitée, du fait de la faible impédance de la borne de polarisation du deuxième transistor, il en résulte l'injection d'un fort courant parasite dans le substrat qui risque de perturber le fonctionnement de l'ensemble des composants présents dans le circuit intégré à la surface du substrat, voire d'endommager ledit circuit. De plus, lorsque le deuxième transistor quitte le régime de saturation pour entrer à nouveau dans un régime de fonctionnement linéaire sous l'effet d'une augmentation du potentiel de la borne de sortie de l'étage, l'évacuation nécessaire de l'importante quantité de charges électriques accumulées dans la base du deuxième transistor génère une impulsion de courant dans le collecteur dudit transistor, le transistor parasite ayant disparu. Or, les bornes d'alimentation du circuit intégré sont reliées par des fils à des broches, présentes sur un boîtier de protection englobant le circuit intégré, broches qui assurent les liaisons électriques entre le circuit intégré et des composants externes au boîtier. Ces fils présentent une inductance intrinsèque qui génère, lorsque soumise à une impulsion de courant, une pointe de tension de très forte valeur qui peut avoir des effets destructeurs, ou, à tout le moins, perturber le potentiel des bornes d'alimentation et, par-là même, le fonctionnement de l'ensemble du circuit intégré.

JP 56 056014 A décrit un circuit amplificateur. Dans ce circuit la conductivité simultanée des transistors de sortie dans un étage supérieur et un étage inférieur est éliminé par l'augmentation d'une tension de sortie minimale au-dessus de la tension de saturation entre le collecteur et l'émetteur d'un transistor appelé « transistor après étage » parmi les transistors de sortie appartenant à l'étage inférieur.

La présente invention a pour but de remédier aux inconvénients décrits dans ce qui précède en proposant un étage de sortie dans lequel la valeur du courant de polarisation du deuxième transistor est contrôlée lorsque ledit transistor se trouve en régime de saturation, le contrôle ainsi effectué étant inopérant lorsque le deuxième transistor se trouve en régime de fonctionnement linéaire.

US-A5 545 918 décrit un circuit intégré comprenant un transistor bipolaire formé dans une couche semi-conductrice. Le transistor bipolaire reçoit un courant d'actionnement à un terminal de base. Un premier transistor parasite et un deuxième transistor parasite sont associés à ce transistor bipolaire. Le deuxième transistor parasite devient actif seulement après que le premier transistor parasite soit devenu actif et quand le courant d'actionnement atteint un niveau prédéterminé. Le circuit intégré comprend des moyens pour éviter un accroissement du courant d'actionnement au-dessus le niveau prédéterminé. Ces moyens deviennent opérationnels seulement quand le second transistor parasite devient actif.

La revendication 1 en annexe définit un étage de sortie selon l'invention. Dans cet étage de sortie, l'entrée en régime de saturation du deuxième transistor provoque une augmentation importante de l'impédance de sa borne de polarisation. La présence de cette forte impédance permet de limiter la valeur du courant de polarisation jusqu'à ce que le deuxième transistor entre à nouveau en régime de fonctionnement linéaire.

La revendication 2 définit un mode de réalisation dans lequel l'information signalant l'entrée en régime de saturation du deuxième transistor est matérialisée sous la forme d'un courant, forme qui est aisément exploitable. Ainsi qu'il sera exposé par la suite, ce mode de réalisation permet d'utiliser pour les modules de détection et d'adaptation d'impédance des structures simples et donc peu coûteuses.

La revendication 3 définit un mode de réalisation, avantageux par sa simplicité, la seule présence d'un courant de détection rend une diode passante, activant ainsi le module d'adaptation d'impédance, ce qui permet la limitation du courant de polarisation du deuxième transistor.

La revendication 4 concerne une structure qui permet d'ajuster, de manière simple et peu coûteuse, la valeur du seuil au-delà duquel le courant de polarisation sera considéré comme représentatif de l'entrée en régime de saturation du deuxième transistor. En effet, lorsque la valeur dudit courant de polarisation dépassera celle de la différence entre les valeurs des courants débités par les deuxième et troisième sources de courant, la sortie du module de détection produira un courant de détection négatif, c'est-à-dire qu'elle appellera depuis l'extérieur un courant dont la valeur sera sensiblement égale à la différence entre le courant de polarisation du deuxième transistor et la valeur du courant débité par la deuxième source de courant.

Si la présente invention peut être utilisée dans tous types de dispositifs nécessitant une amplification, sa mise en oeuvre est particulièrement avantageuse dans des dispositifs de sélection de signaux radioélectriques, que l'on trouve couramment dans des récepteurs de télévision ou des appareils de radiotéléphonie. L'invention concerne donc également un dispositif de sélection de signaux radioélectriques, comportant :
- un système d'antenne et de filtrage destiné à délivrer sur une sortie un signal électronique ayant une fréquence dite fréquence radio et représentatif du signal radioélectrique sélectionné,
- un oscillateur destiné à délivrer un signal de sortie dont la fréquence, dite fréquence d'oscillation, est réglable,
- un mélangeur destiné à recevoir les signaux de sortie de l'oscillateur et du système d'antenne et de filtrage, et à délivrer un signal de sortie dont la fréquence, dite intermédiaire, est égale à la différence entre la fréquence radio et la fréquence d'oscillation, et
- un amplificateur destiné à amplifier le signal de sortie du mélangeur, dispositif dans lequel l'amplificateur est muni d'un étage de sortie conforme à la revendication 1.

L'étage de sortie conforme à l'invention permet d'éviter que de forts courants parasites ne se propagent dans le substrat à la fréquence intermédiaire, ce qui pourrait altérer la fréquence oscillation, et donc dégrader la précision de la sélection opérée par le dispositif. De plus, un tel courant parasite serait la cause d'un décalage de fréquence de nature à perturber le traitement du signal issu du dispositif de sélection. De telles dégradations seraient ultimement perçues par l'utilisateur de l'appareil incorporant le dispositif de sélection, et provoqueraient chez cet utilisateur un inconfort qui doit être minimisé autant que possible, ce qui est obtenu grâce à la présente invention.

L'invention sera mieux comprise à l'aide de la description suivante, faite à titre d'exemple non-limitatif et en regard des dessins annexés, dans lesquels :
- la figure 1 est un schéma fonctionnel partiel décrivant un dispositif de sélection de signaux radioélectriques,
- la figure 2 est un schéma fonctionnel décrivant un amplificateur muni d'un étage de sortie conforme à l'invention, et
- la figure 3 est un schéma électrique décrivant un étage de sortie conforme à un mode de réalisation préféré de l'invention.

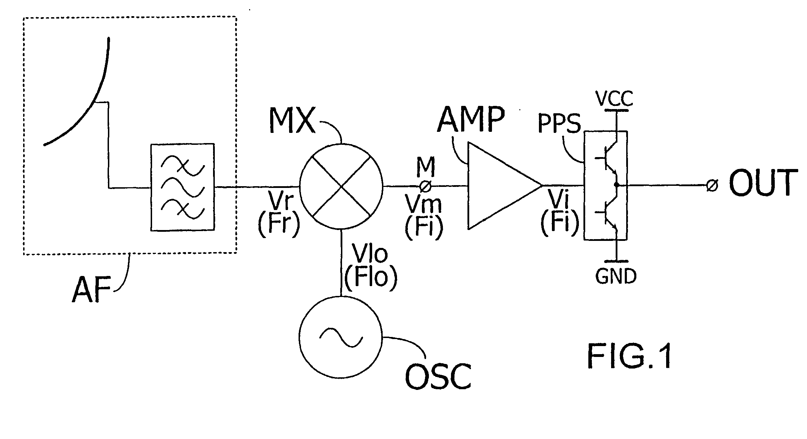

La figure 1 représente schématiquement un dispositif de sélection de signaux radioélectriques, comportant :
. un système d'antenne et de filtrage AF destiné à délivrer sur une sortie un signal électronique Vr ayant une fréquence dite fréquence radio Fr et représentatif du signal radioélectrique sélectionné,
. un oscillateur OSC destiné à délivrer un signal de sortie Vlo dont la fréquence Flo, dite fréquence d'oscillation, est réglable,
. un mélangeur MX destiné à recevoir les signaux de sortie de l'oscillateur OSC et du système d'antenne et de filtrage AF, et à délivrer sur une borne de sortie M un signal de sortie Vm ayant une fréquence Fi, dite intermédiaire, prédéterminée égale à la différence entre la fréquence radio et la fréquence d'oscillation Fr-Flo, ce qui est couramment réalisé au moyen d'un filtre passe-bande sélectionnant ladite fréquence intermédiaire Fi, et
. un amplificateur AMP destiné à amplifier le signal de sortie du mélangeur MX et à délivrer un signal de sortie Vi résultant de cette amplification.

L'amplificateur AMP est muni d'un étage de sortie PPS de type «push-pull», constitué de deux transistors dont les trajets principaux de courant sont disposés en série entre une première et une deuxième bornes d'alimentation VCC et GND, le noeud intermédiaire entre lesdits transistors formant la borne de sortie OUT du dispositif de sélection.

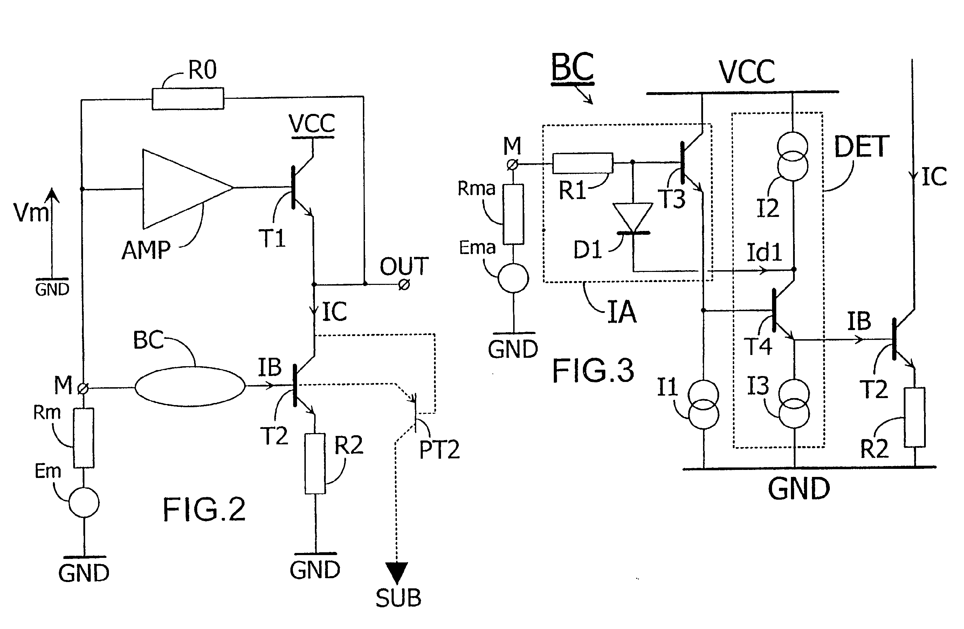

La figure 2 est un schéma fonctionnel qui représente plus en détail l'étage de sortie de l'amplificateur AMP, et permet de mieux appréhender le problème technique posé par les étages de sortie connus. Le mélangeur MX est représenté sous la forme de son générateur de Thévenin équivalent (Em, Rm), disposé entre la borne de sortie M du mélangeur, qui constitue aussi l'entrée de l'amplificateur AMP, et la deuxième borne d'alimentation GND. L'étage de sortie comporte un premier et un deuxième transistor T1, T2. Dans l'exemple représenté ici, les premier et deuxième transistors T1 et T2 sont des transistors bipolaires de type NPN, dont les bases, les émetteurs et les collecteurs constituent respectivement des bornes de polarisation, des bornes de référence et des bornes de transfert. Les premier et deuxième transistors T1 et T2 ont des trajets de courant principaux définis comme les trajets borne de transfert - borne de référence, constitués dans cet exemple par leurs jonctions collecteur-émetteur. Ces trajets de courant principaux sont disposés entre une première et une deuxième borne d'alimentation VCC et GND, un noeud intermédiaire entre lesdits trajets de courant formant une borne de sortie OUT de l'étage. La base du premier transistor T1 est reliée à une sortie de l'amplificateur AMP, la base du deuxième transistor T2 étant reliée à l'entrée de l'amplificateur AMP via un circuit de polarisation BC. Dans cet exemple, une résistance dite de boucle R0 relie la borne de sortie OUT de l'étage à ladite entrée de l'amplificateur AMP. La fonction de cette résistance de boucle est d'améliorer la linéarité de l'amplification réalisée par l'amplificateur AMP, selon un principe bien connu de l'homme du métier. Le trajet de courant principal du deuxième transistor T2 est destiné à être parcouru par un courant IC, tandis que sa base reçoit un courant de polarisation IB. Lorsque la valeur de ce courant devient suffisamment importante, le deuxième transistor T2 quitte un régime de fonctionnement linéaire, au cours duquel le courant de polarisation IB est égal à IC/β, où β est le gain du deuxième transistor, pour entrer dans un régime de saturation. Le deuxième transistor T2 présente alors un transistor parasite PT2 ayant un type de conductivité opposé à celui du deuxième transistor T2, c'est-à-dire de type PNP dans cet exemple, transistor parasite PT2 dont les base, émetteur et collecteur, sont respectivement constituées par le collecteur, la base et le substrat SUB du deuxième transistor PT2. Le deuxième transistor T2 étant saturé, il reçoit sur sa base un courant de polarisation IB qui est dirigé, via le trajet de courant principal du transistor parasite PT2, vers le substrat SUB. Si l'impédance de la base du deuxième transistor T2 est faible, rien ne limite la valeur du courant de polarisation IB, ce qui est précisément le cas pour les étages de sortie connus, dans lesquels la base du deuxième transistor T2 est reliée à l'entrée de l'amplificateur AMP, dont l'impédance équivalente est nécessairement faible, ce qui est à fortiori le cas dans cet exemple, du fait de la résistance de boucle R0. Si la valeur dudit courant de polarisation IB n'est pas limitée du fait d'une trop faible impédance de la base du deuxième transistor T2, il en résulte l'injection d'un fort courant parasite IB dans le substrat SUB qui risque de perturber le fonctionnement de l'ensemble des composants présents dans le dispositif de sélection intégré à la surface du substrat SUB, voire d'endommager ledit dispositif.

La figure 3 est un schéma électrique qui représente un circuit de polarisation BC présent dans un étage de sortie conforme à un mode de réalisation préféré de l'invention. Ce circuit de polarisation BC comporte :
. un module de détection DET destiné à signaler l'entrée en régime de saturation du deuxième transistor T2, et
. un module d'adaptation d'impédance IA destiné, lorsqu'il est activé, à attribuer à la base du deuxième transistor T2 une impédance élevée lorsque ledit transistor T2 entre en saturation.

Le module de détection DET est muni de moyens pour produire sur une sortie un courant Id1 dit de détection lorsque la valeur du courant de polarisation IB du deuxième transistor T2 dépasse un seuil prédéterminé, ledit courant de détection Id1 étant destiné à activer le module d'adaptation d'impédance IA.

Le module d'adaptation d'impédance IA comporte un troisième transistor T3, dont la base est reliée à l'entrée M de l'amplificateur via une résistance R1, dont le trajet de courant principal est disposé, en série avec une première source de courant I1, entre les première et deuxième bornes d'alimentation VCC et GND, l'émetteur du troisième transistor T3 étant relié, via le module de détection DET, à la base du deuxième transistor T2, la base du troisième transistor T3 étant reliée, via une diode D1, à la sortie du module de détection DET. Le module de détection DET comporte un quatrième transistor T4, dont la base est reliée à l'émetteur du troisième transistor T3, dont les collecteur et émetteur sont respectivement reliés, via des deuxième et troisième sources de courant I2 et I3, aux première et deuxième bornes d'alimentation VCC et GND, le collecteur du quatrième transistor T4 formant la sortie du module de détection DET, l'émetteur dudit transistor T4 étant relié à la base du deuxième transistor T2.

Le générateur (Ema, Rma) représente le générateur de Thévenin équivalent au mélangeur en parallèle avec l'amplificateur, vu depuis l'entrée M dudit amplificateur.

Le fonctionnement du circuit de polarisation BC peut être décrit comme suit : Lorsque le deuxième transistor T2 est en régime de fonctionnement linéaire, c'est-à-dire tant que IB=IC/β, où β est le gain du deuxième transistor T2, l'impédance de base dudit transistor T2 est de l'ordre de la dizaine d'Ohms, puisque sensiblement égale à l'impédance de l'émetteur du quatrième transistor T4. Le courant de polarisation IB est alors de l'ordre de la centaine de microAmpères. La valeur du courant débité par la deuxième source de courant I2 est choisie, dans cet exemple, légèrement supérieure à celle du courant débité par la troisième source de courant : I2-I3=ΔI. Cette différence ΔI constitue la valeur du seuil prédéterminé au-delà duquel le courant de polarisation IB sera considéré comme représentatif de l'entrée en régime de saturation du deuxième transistor T2. Lorsque, sous l'effet d'un courant collecteur IC croissant, le courant de polarisation IB dépasse la valeur du seuil prédéterminé ΔI, la diode D1 entre en conduction afin de fournir à la base du deuxième transistor T2 le surplus de courant que ne peut délivrer la deuxième source de courant I2. En d'autres termes, le module de détection DET produit alors un courant de détection Id1 qui active le module d'adaptation d'impédance IA. En effet, la diode D1, devenue passante sous l'effet du courant de détection Id1, relie la résistance R1 à la base du deuxième transistor T2 via le trajet de courant principal du quatrième transistor T4. L'impédance de la base du deuxième transistor T2 devient alors sensiblement égale à la résistance R1, laquelle, si elle est choisie suffisamment grande, permet de limiter la valeur du courant de polarisation IB, et donc la valeur du courant parasite injecté dans le substrat. Dans les étages de sortie connus, la valeur du courant parasite est de l'ordre de la dizaine de milliAmpères. En choisissant pour la résistance R1 une valeur de l'ordre du kiloOhm, et à dimensions de composants et tension d'alimentation comparables, le courant parasite peut être limité à une valeur de l'ordre du milliAmpère, ce qui constitue une réduction d'un facteur 10. Lorsque le courant de polarisation IB diminue en dessous de la valeur du seuil prédéterminé ΔI, la deuxième source de courant I2 est à nouveau en mesure de délivrer la totalité du courant de polarisation IB, et le module de détection DET signale, par l'interruption du courant de détection Id1, l'entrée en régime de fonctionnement linéaire du deuxième transistor T2. La diode D1 se bloque alors, et le module d'adaptation d'impédance IA est désactivé. Le module d'adaptation d'impédance IA n'a donc pas d'influence significative sur le fonctionnement du circuit de polarisation BC lorsque le deuxième transistor T2 se trouve en régime de fonctionnement linéaire.

Il est bien entendu que si, dans l'exemple de réalisation décrit ci-dessus, les transistors inclus dans l'étage de sortie sont des transistors bipolaires, d'autres modes de réalisation peuvent mettre en oeuvre des transistors à effet de champ, dont les grilles, drains et sources constitueront alors les bornes de polarisation, de transfert et de référence.

## Revendications

1. Etage de sortie (PPS) pour amplificateur (AMP), comportant un premier et un deuxième transistor (T1, T2), chacun muni d'une borne de polarisation, d'une borne de référence et d'une borne de transfert, lesdits transistors ayant leurs trajets de courant principaux disposés entre une première et une deuxième borne d'alimentation (VCC, GND), un noeud intermédiaire entre lesdits trajets de courant formant une borne de sortie (OUT) de l'étage, la borne de polarisation du premier transistor étant reliée à une sortie de l'amplificateur, la borne de polarisation du deuxième transistor étant reliée à une entrée de l'amplificateur via un circuit de polarisation (BC),
étage de sortie **caractérisé en ce que** le circuit de polarisation comporte :
. un module de détection(DET) destiné à signaler l'entrée en régime de saturation du deuxième transistor (T2), et
. un module d'adaptation d'impédance (IA) destiné, lorsqu'il est activé, à attribuer à la borne de polarisation du deuxième transistor une impédance élevée (R1) lorsque ledit transistor entre en saturation.

2. Etage de sortie selon la revendication 1, **caractérisé en ce que** le module de détection (DET) est muni de moyens (T4, I2, I3) pour produire sur une sortie un courant (Id1) dit de détection lorsque la valeur du courant de la borne de polarisation (IB) du deuxième transistor (T2) dépasse un seuil prédéterminé, ledit courant de détection étant destiné à activer le module d'adaptation d'impédance (IA).

3. Etage de sortie selon la revendication 2, **caractérisé en ce que** le module d'adaptation d'impédance (IA) comporte un troisième transistor (T3), dont la borne de polarisation est reliée à l'entrée de l'amplificateur (AMP) via une résistance (R1), dont le trajet de courant principal est disposé, en série avec une première source de courant (I1), entre les première et deuxième bornes d'alimentation (VCC, GND), la borne de référence du troisième transistor (T3) étant reliée, via le module de détection (DET), à la borne de polarisation du deuxième transistor (T2), la borne de polarisation du troisième transistor étant en outre reliée, via une diode (D1), à la sortie du module de détection.

4. Etage de sortie selon la revendication 3, **caractérisé en ce que** le module de détection (DET) comporte un quatrième transistor (T4), dont la borne de polarisation est reliée à la borne de référence du troisième transistor (T3), dont les bornes de transfert et de référence sont respectivement reliées, via des deuxième et troisième sources de courant (I2, 13), aux première et deuxième bornes d'alimentation (VCC, GND), la borne de transfert du quatrième transistor formant la sortie du module de détection, la borne de référence dudit transistor étant reliée à la borne de polarisation du deuxième transistor (T2).

5. Dispositif de sélection de signaux radioélectriques, comportant :
. un système d'antenne et de filtrage (AF) destiné à délivrer sur une sortie un signal électronique (Vr) ayant une fréquence dite fréquence radio (Fr) et représentatif du signal radioélectrique sélectionné,
un oscillateur (OSC) destiné à délivrer un signal de sortie (Vlo) dont la fréquence (Flo), dite fréquence d'oscillation, est réglable, .
. un mélangeur (MX) destiné à recevoir les signaux de sortie de l'oscillateur et du système d'antenne et de filtrage, et à délivrer un signal de sortie (Vm) dont la fréquence (Fi) est égale à la différence entre la fréquence radio et la fréquence d'oscillation, et
un amplificateur (AMP) destiné à amplifier le signal de sortie du mélangeur, dispositif de sélection **caractérisé en ce que** l'amplificateur est muni d'un étage de sortie (PPS) conforme à la revendication 1.

## Claims

1. Output stage (PPS) for amplifier (AMP), comprising a first and a second transistor (T1,T2), each furnished with a bias terminal, with a reference terminal and with a transfer terminal, the said transistors having their main current paths disposed between a first and a second supply terminal (VCC, GND), an intermediate node between the said current paths forming an output terminal (OUT) of the stage, the bias terminal of the first transistor being linked to an output of the amplifier, the bias terminal of the second transistor being linked to an input of the amplifier via a bias circuit (BC),
output stage **characterized in that** the bias circuit comprises:
. a detection module (DET) intended to signal the entry of the second transistor (T2) into the saturation regime, and
. an impedance matching module (IA) intended, when it is activated, to allocate the bias terminal of the second transistor a high impedance (R1) when the said transistor enters saturation.

2. Output stage according to Claim 1, **characterized in that** the detection module (DET) is furnished with means (T4, I2, I3) for producing on an output a so-called detection current (Id1) when the value of the current of the bias terminal (IB) of the second transistor (T2) exceeds a predetermined threshold, the said detection current being intended to activate the impedance matching module (IA).

3. Output stage according to Claim 2, **characterized in that** the impedance matching module (IA) comprises a third transistor (T3), whose bias terminal is linked to the input of the amplifier (AMP) via a resistor (R1), whose main current path is disposed, in series with a first current source (I1), between the first and second supply terminals (VCC, GND), the reference terminal of the third transistor (T3) being linked, via the detection module (DET), to the bias terminal of the second transistor (T2), the bias terminal of the third transistor being furthermore linked, via a diode (D1), to the output of the detection module.

4. Output stage according to Claim 3, **characterized in that** the detection module (DET) comprises a fourth transistor (T4), whose bias terminal is linked to the reference terminal of the third transistor (T3), whose transfer and reference terminals are respectively linked, via second and third current sources (I2,I3), to the first and second supply terminals (VCC,GND), the transfer terminal of the fourth transistor forming the output of the detection module, the reference terminal of the said transistor being linked to the bias terminal of the second transistor (T2).

5. Device for selecting radioelectric signals, comprising:
. an antenna and filtering system (AF) intended to deliver on an output an electronic signal (Vr) which has a frequency termed the radio frequency (Fr) and is representative of the selected radioelectric signal,
. an oscillator (OSC) intended to deliver an output signal (VLo) whose frequency (FLo), termed the oscillation frequency, is adjustable,
. a mixer (MX) intended to receive the output signals of the oscillator and of the antenna and filtering system, and to deliver an output signal (Vm) whose frequency (Fi) is equal to the difference between the radio frequency and the oscillation frequency, and
. an amplifier (AMP) intended to amplify the output signal of the mixer,
selection device **characterized in that** the amplifier is furnished with an output stage (PPS) in accordance with Claim 1.

## Patentansprüche

1. Ausgangsstufe (PPS) für einen Verstärker (AMP), die einen ersten und einen zweiten Transistor (T1, T2) umfasst, die jeweils einen Polarisationsanschluss, einen Referenzanschluss und einen Übertragungsanschluss aufweisen, wobei Hauptstrombahnen der besagten Transistoren zwischen einem ersten und einem zweiten Versorgungsanschluss (VCC, GND) liegen, wobei ein Zwischenknoten zwischen den besagten Strombahnen einen Ausgang der Ausgangsstufe (OUT) bildet, der Polarisationsanschluss des ersten Transistors mit einem Ausgang des Verstärkers verbunden ist und der Polarisationsanschluss des zweiten Transistors über einen Polarisationsschaltkreis (BC) mit einem Eingang des Verstärkers verbunden ist,
wobei die Ausgangsstufe **dadurch gekennzeichnet ist, dass** der Polarisationskreislauf folgendes umfasst:
- ein Erfassungsmodul (DET) zum Signalisieren des Eintretens des zweiten Transistors (T2) in einen Sättigungszustand und,
- ein Impedanzanpassungsmodul (IA) zum Zuordnen einer hohen Impedanz (R1), wenn es aktiviert ist, an den Polarisationsanschluss des zweiten Transistors, wenn sich dieser Transistor in dem Sättigungszustand befindet.

2. Ausgangsstufe nach Anspruch 1, **dadurch gekennzeichnet, dass** das Erfassungsmodul (DET) über Mittel (T4, 12, 13) verfügt, um an einem Ausgang einen Erfassungsstrom genannten Strom (Id1) zu erzeugen, wenn der Wert des Stromes am Polarisationsanschluss (IB) des zweiten Transistors (T2) über einen vorgegebenen Schwellenwert ansteigt, wobei der besagte Erfassungsstrom zum Aktivieren des lmpedanzanpassungsmoduls (IA) dient.

3. Ausgangsstufe nach Anspruch 2, **dadurch gekennzeichnet, dass** das lmpedanzanpassungsmodul (IA) einen dritten Transistor (T3) umfasst, dessen Polarisationsanschluss über einen Widerstand (R1) mit dem Eingang des Verstärkers (AMP) verbunden ist, wobei die Hauptstrombahn des dritten Transistors in Serie mit einer ersten Stromquelle (I1) zwischen dem ersten und zweiten Versorgungsanschluss (VCC, GND) angeordnet ist, wobei der Referenzanschluss des dritten Transistors (T3) über das Erfassungsmodul (DET) mit dem Polarisationsanschluss des zweiten Transistors (T2) verbunden ist, und
wobei der Polarisationsanschluss des dritten Transistors darüber hinaus über eine Diode (D1) mit dem Ausgang des Erfassungsmoduls verbunden ist.

4. Ausgangsstufe nach Anspruch 3, **dadurch gekennzeichnet, dass** das Erfassungsmodul (DET) einen vierten Transistor (T4) umfasst, dessen Polarisationsanschluss mit dem Referenzanschluss des dritten Transistors (T3) verbunden ist, dessen Übertragungs- und Referenzanschluss jeweils über zweite und dritte Stromquellen (12, 13) mit dem ersten und zweiten Versorgungsanschluss (VCC, GND) verbunden sind, und wobei der Übertragungsanschluss des vierten Transistors den Ausgang des Erfassungsmoduls bildet und der Referenzanschluss des besagten Transistors mit dem Polarisationsanschluss des zweiten Transistors (T2) verbunden ist.

5. Auswahlvorrichtung für funkelektrische Signale, die folgendes umfasst:
- ein Antennen- und Filtersystem (AF), das ausgebildet ist, ein elektronisches Signal (Vr) mit einer Funkfrequenz (Fr) genannten Frequenz über einen Ausgang zu liefern, wobei dieses Signal für das gewählte funkelektrische Signal repräsentativ ist,
- einen Schwingkreis (OSC), der ausgebildet ist, ein Ausgangssignal (Vlo) zu liefern, dessen Schwingungsfrequenz genannte Frequenz (Flo) einstellbar ist,
- eine Mischerstufe (MX), welche ausgebildet ist, die Ausgangssignale des Schwingkreises und des Filterantennensystems zu empfangen und ein Ausgangssignal (Vm) zu liefern, dessen Frequenz (Fi) der Differenz zwischen der Funkfrequenz und der Schwingungsfrequenz gleicht, und
- einen Verstärker (AMP), der ausgebildet ist, das Ausgangssignal der Mischerstufe zu verstärken,
wobei die Auswahlvorrichtung **dadurch gekennzeichnet ist, dass** der Verstärker eine Ausgangsstufe (PPS) nach Anspruch 1 aufweist.
